# EUROPEAN PATENT SPECIFICATION

(11) **EP 1 801 360 B1**
(45) Date of publication and mention of the grant of the patent: **14.11.2012**
(21) Application number: 06126323.2
(22) Date of filing: 18.12.2006
(51) Int. Cl.: F01D 5/08, F01D 11/02, F02C 7/28, C23C 14/04, F01D 25/00

(54) **Methods and apparatus for fabricating turbine engine components**
Verfahren und Vorrichtung zur Herstellung eines Bauteils einer Turbine
Procédé et dispositif de fabrication d'éléments de turbine

(30) Priority: 20.12.2005 US 312123
(43) Date of publication of application: 27.06.2007
(73) Proprietor: GENERAL ELECTRIC COMPANY, Schenectady, NY 12345 (US)
(72) Inventor: Tefft, Stephen Wayne, Cincinnati, OH 45241 (US)
(74) Representative: Williams, Andrew Richard

(56) References cited:
- GB-A- 841 838
- US-A- 3 147 142
- US-A- 4 155 152
- US-A1- 2004 134 066

## Description

The methods and apparatus described and/or illustrated herein relate generally to turbine engines, and more specifically to fabricating turbine engine components.

At least some known turbine engine components are coated with a metallic and/or ceramic coating, for example a thermal barrier coating (TBC) or a wear-resistant coating, to shield such components from high temperature gas flows generated within the engine. However, the application of a coating may sometimes adversely affect and/or limit the performance of some components exposed to the gas flow path. Accordingly, some components are at least partially masked before application of the coating such that the coating does not coat all or a portion of the component. For example, surfaces defined between adjacent seal teeth, which may be used with rotating seals within the engine, are sometimes masked to prevent the coating from coating such surfaces.

Some known turbine engine components are masked using an adhesive-backed tape, for example glass-filled masking tape. However, applying and removing tape may be time consuming and difficult, for example because of tight tolerances of the masked component or component portion, which may increase a cost and/or a cycle time of fabricating the component. For example, it may be difficult and/or time consuming to apply tape to surfaces defined between adjacent seal teeth, because of a size of spaces between adjacent teeth. Moreover, because some of the coating applied adjacent the masked component or component portion may overlap the tape, removal of the tape after the coating has been applied may cause the coating to chip, which may adversely affect and/or limit performance of the coating. Furthermore, tape used to mask a component or component portion may not be reusable once removed from the component or component portion, which may increase a cost of fabricating a plurality of the components. Some known turbine engine components are masked using rubber bands. For example, surfaces defined between adjacent seal teeth are sometimes masked with rubber bands. At least some known coatings are applied by spraying a powder onto the surface being coated. However, some particles of the sprayed powder may bounce off some known rubber bands such that the surface may not be evenly coated, which may adversely affect or limit performance of the coating. Furthermore, as with some known tape, some of the coating applied adjacent the masked component or component portion may overlap the rubber band, which may cause the coating to chip during removal of the rubber band. Moreover, some known rubber bands may lose some elasticity and/or shape such that, as with some known tape, the band may not be reusable once removed from the component or component portion.

In one aspect according to the present invention, an assembly includes a mask including a body and an opening within the body. The assembly also includes a component including a rotor and an extension extending radially outward from the rotor. The mask body is positioned with respect to the component such that at least a portion of the extension is received within the opening during rotation of the component relative to the mask. The mask body is positioned with respect to the component such that the body is configured to facilitate reducing deposition of a coating to a portion of the component adjacent the extension during application of the coating to at least a portion of the extension.

In another aspect, a method is provided for masking at least a portion of a component during application of a coating. The component includes a rotor and a plurality of extensions extending radially outward from the rotor along at least a portion of a circumference of the rotor and spaced axially along an axis of rotation of the rotor. The method includes positioning a mask having a plurality of openings between the component and a tool applying the coating such that at least a portion of each of the plurality of extensions is received within an opening of the plurality of mask body openings and such that at least a portion of the mask body extends through a channel defined between two adjacent extensions, rotating the rotor relative to the mask body, and applying a coating to at least a portion of each of the plurality of extensions such that the mask facilitates reducing contact between the coating and a surface of the channel defined between two adjacent extensions.

Various aspects and embodiments of the present invention will now be described in connection with the accompanying drawings, in which:
Figure 1 is schematic illustration of an exemplary gas turbine engine.
Figure 2 is a cross-sectional view of an exemplary seal that may be used within the gas turbine engine shown in Figure 1.
Figure 3 is a top plan view of an exemplary embodiment of a mask for use masking a portion of the seal shown in Figure 2 during application of a coating thereto.
Figure 4 is a cross-sectional view of the mask shown in Figure 3 taken along line 4-4 of Figure 3.
Figure 5 is a cross-sectional view of an assembly including the seal shown in Figure 2, the mask shown in Figures 3 and 4, and a tool for use applying the coating to a portion of the seal shown in Figure 2.

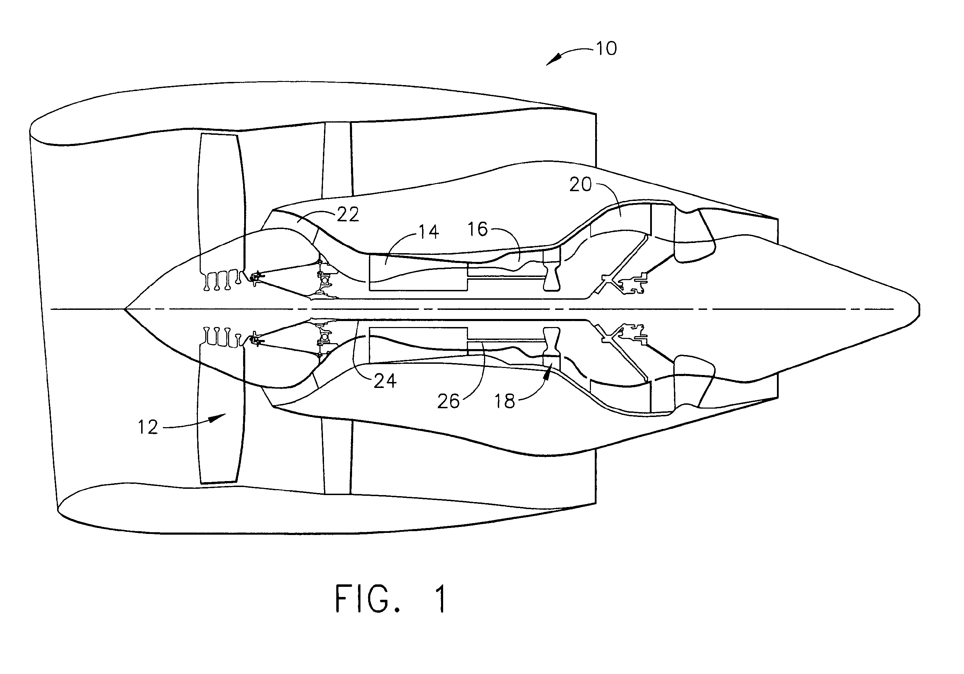

Figure 1 is a schematic illustration of an exemplary gas turbine engine 10 including a low pressure compressor 12, a high pressure compressor 14, and a combustor 16. Engine 10 also includes a high pressure turbine 18 and a low pressure turbine 20. Compressor 12 and turbine 20 are coupled by a first shaft 24, and compressor 14 and turbine 18 are coupled by a second shaft 26. Although engine 10 may be other engines, in some embodiments engine 10 is a GE90 available from General Electric Company, Cincinnati, Ohio. In operation, air flows through low pressure compressor 12 and compressed air is supplied from low pressure compressor 12 to high pressure compressor 14. The highly compressed air is delivered to combustor 16. Airflow from combustor 16 drives turbines 18 and 20 before exiting gas turbine engine 10.

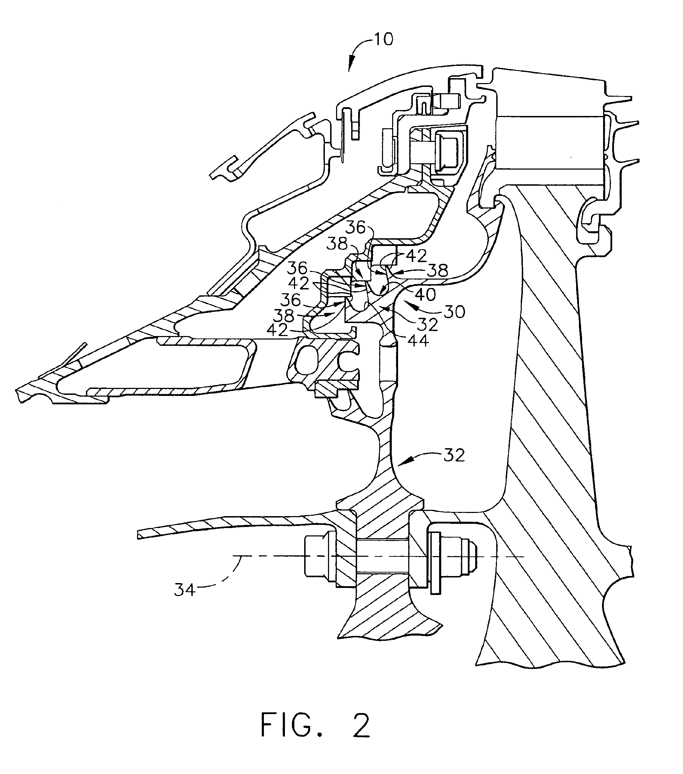

Figure 2 is a cross-sectional view of an exemplary seal 30 that may be used within gas turbine engine 10. Seal 30 includes a rotor 32 that rotates within engine 10 about an axis of rotation 34, and a plurality of seal teeth 36 that extend radially outward from rotor 32. Seal 30 may be any seal that rotates within engine 10 and includes at least one seal tooth 36, such as, but not limited to, a forward outer seal and a compressor discharge pressure seal. Although three seal teeth 36 are illustrated, seal 30 may include any number of seal teeth 36. Although seal teeth 36 may have any suitable size, shape, orientation, location, configuration, and/or arrangement on rotor 32, in the exemplary embodiment each seal tooth 36 extends substantially circumferentially around rotor 32. However, in some embodiments one or more seal teeth 36 may extend radially outward along only a portion of a circumference of rotor 32. Moreover, and although seal teeth 36 may have any suitable size, shape, orientation, location, configuration, and/or arrangement on rotor 32, in the exemplary embodiment the plurality of seal teeth 36 are arranged in axially-spaced rows 38 such that each seal tooth 36 is spaced apart from adjacent seal teeth 36 along rotor axis of rotation 34. As such, a channel 40 is defined between adjacent seal teeth 36. More specifically, each channel 40 is defined by sidewalls 42 of adjacent seal teeth 36 that face each other and a radially inner surface 44 extending between sidewalls 42. Each channel 40 may have any suitable size and/or shape. For example, in the exemplary embodiment, and although each channel 40 may include other shapes, each channel 40 includes a generally U-shaped cross-sectional profile.

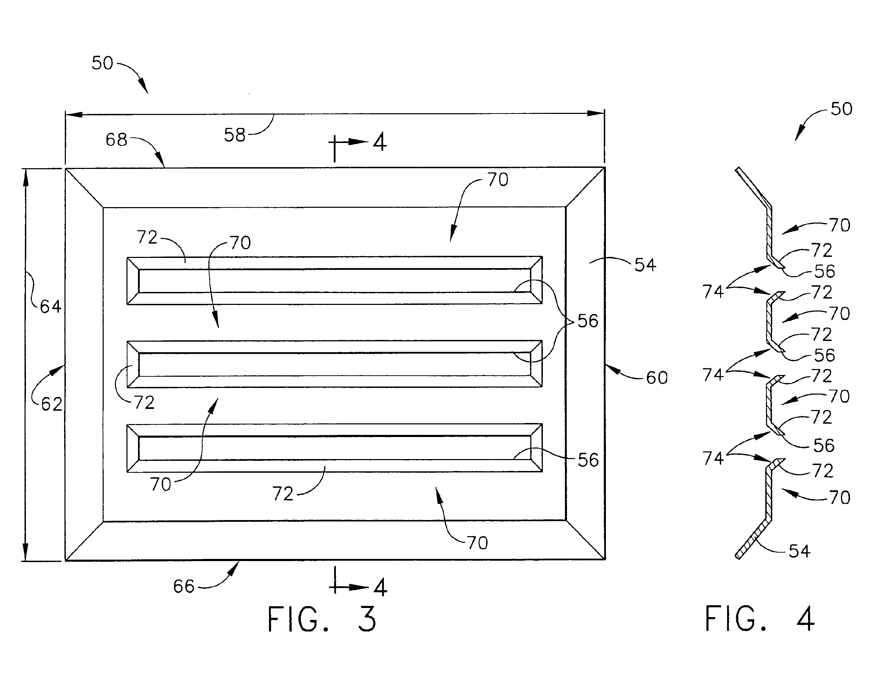

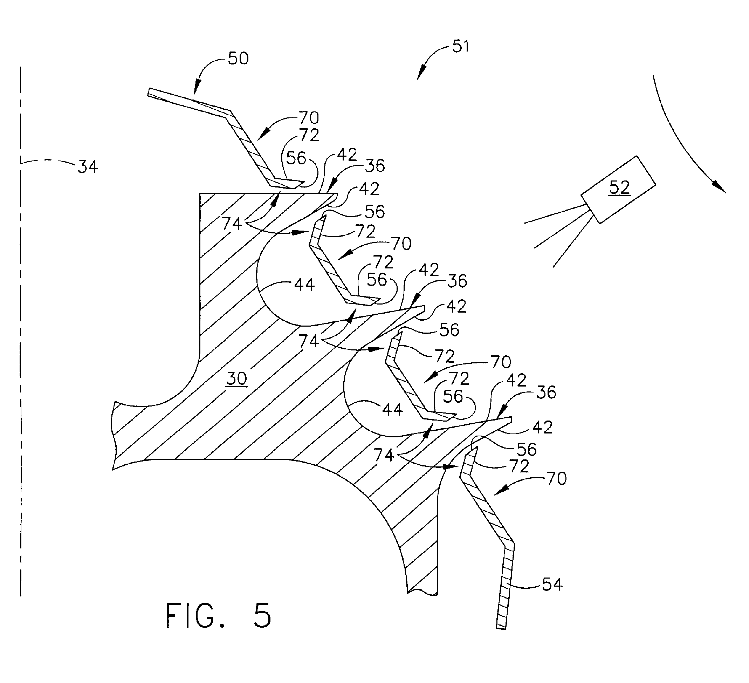

Figure 3 is a top plan view of an exemplary embodiment of a mask 50 for masking a portion of seal 30 during application of a coating thereto, as will be described in more detail below. Figure 4 is a cross-sectional view of mask 50 taken along line 4-4 of Figure 3. Figure 5 is a cross-sectional view of an assembly 51 including mask 50, seal 30, and a tool 52 for use applying a coating to seal 30. Mask 50 includes a body 54 and a plurality of openings 56 within body 54. Each opening 56 receives at least a portion of a seal tooth 36 therein, as shown in Figure 5. Mask body 54 may have any suitable size and/or shape that enables mask 50 to function as described herein. In the exemplary embodiment, and although mask body 54 may include other shapes, mask body 54 is generally rectangular and extends a length 58 measured between opposite end portions 60 and 62, and extends a width 64 measured between opposite end portions 66 and 68. Mask body 54 shape, length 58, and/or width 64 may be variably selected depend portioning on a type, size, and/or shape of seal 30 and/or any portion thereof. Although mask 50 is herein described and illustrated in the exemplary manner, it should be understood that the size, shape, configuration, orientation, arrangement, and/or location of mask 50 and any portion and/or feature thereof may vary depend on the particular size, shape, configuration, orientation, arrangement, and/or location of seal 30. The illustrated embodiment is intended as exemplary, and is not intended to limit the size, shape, configuration, orientation, arrangement, and/or location of mask 50, any portion and/or feature of mask 50, and/or seal 30.

As shown in Figure 5, mask 50 is positionable with respect to seal 30 such that a portion of each seal tooth 36 is received within a corresponding opening 56. A plurality of portions 70 of mask body 54 that are each defined adjacent a mask body opening 56 and/or between adjacent mask body openings 56 each facilitate reducing or eliminating application of a coating to a corresponding channel radially inner surface 44 (and/or in some embodiments at least a portion of seal teeth sidewalls 42 and/or other portions of seal 30), as will be described in more detail below. For example, mask 50 is positionable such that mask body portions 70 each extend through a corresponding channel 40 between adjacent seal teeth.

Each mask body opening 56 may include any suitable size and/or shape, and/or any suitable configuration, orientation, arrangement, and/or location on mask body 54, that enable openings 56 to function as described herein. For example, each mask body opening 56 may include any suitable size and/or shape, and/or any suitable configuration, orientation, arrangement, and/or location on mask body 54, that enable each opening 56 to receive a portion of a corresponding seal tooth 36. Although each opening 56 may include other configurations, orientations, arrangements, and/or locations with respect to mask body 54, in the exemplary embodiment each opening 56 is an elongate opening extending along a portion of mask body length 58 between mask body end portion portions 60 and 62, and extending substantially parallel to length 58. Moreover, although each opening 56 may include other shapes, such as, but not limited to, an oval shape, in the exemplary embodiment each opening 56 is generally rectangular. A size and/or shape, and/or a configuration, orientation, arrangement, and/or location on mask body 54, of one or more openings 56 may be variably selected depend portioning on a type, size, and/or shape of seal 30 and/or any portion thereof. For example, a size and/or shape, and/or a configuration, orientation, arrangement, and/or location on mask body 54, of one or more openings 56 may be variably selected depend portioning on a size and/or shape of seal teeth 36 and/or channels 40.

Similarly, each mask body portion 70 may include any suitable size and/or shape, and/or any suitable configuration, orientation, arrangement, and/or location on mask body 54, that enable portions 70 to function as described herein. For example, each mask body portion 70 may include any suitable size and/or shape, and/or any suitable configuration, orientation, arrangement, and/or location on mask body 54, that enable each portion 70 to facilitate reducing application of a coating to channel radially inner surfaces 44, at least a portion of seal teeth sidewalls 42, and/or other portions of seal 30. Although each portion 70 may include other shapes, such as, but not limited to, a shape including a curved side, in the exemplary embodiment each portion 70 is generally rectangular. A size and/or shape, and/or a configuration, orientation, arrangement, and/or location on mask body 54, of one or more portions 70 may be variably selected depend portioning on a type, size, and/or shape of seal 30 and/or any portion thereof. For example, a size and/or shape, and/or a configuration, orientation, arrangement, and/or location on mask body 54, of one or more portions 70 may be variably selected depend portioning on a size and/or shape of seal teeth 36 and/or channels 40. In the exemplary embodiment, each mask body opening 56 is defined by a flange 72 extending generally outward from mask body 54. More specifically, each mask body opening 56 is defined by an outer end portion 74 of each flange 72. Flanges 72 may facilitate further reducing or eliminating application of a coating to a corresponding channel radially inner surface 44, at least a portion of seal teeth sidewalls 42, and/or other portions of seal 30. Flanges 72 may extend at generally any suitable angle with respect to mask body 54 that enable flanges 72 to function as described herein. For example, in the exemplary embodiment flanges 72 extend substantially obliquely with respect to mask body 54. In other embodiments, one or more flanges 72 extend substantially perpendicular to mask body 54. In some embodiments, mask body 54 does not include one or more flanges 72 extending outwardly therefrom such that one or more openings are not defined by a flange end portion 74.

To shield engine components from temperatures generated therein, components exposed to the temperatures may be coated with any suitable coating, such as, but not limited to, a thermal barrier coating (TBC) and/or a wear-resistant coating. The coating may either facilitate reducing heat transfer into the components, which may permit the engine to operate with an increased operating temperature for increasing an efficiency of the engine, and/or facilitate providing wear resistance to the components being coated. Although the coating may include any suitable material, some exemplary known coatings include, but are not limited to, a metallic material and/or a ceramic material. For example, some known coatings include a metallic bond layer applied to the component, and a ceramic layer applied to the metallic bond layer. Moreover, before some known coatings are applied, one or more surfaces of the component may be grit-blasted to facilitate adhesion of the coating to the surface(s). As described in more detail below, mask 50 facilitates reducing or eliminating contact between the coating and channel radially inner surfaces 44, at least a portion of seal teeth sidewalls 42, and/or other portions of seal 30 during application of the coating to seal 30.

To apply the coating to seal 30, mask 50 is positioned between tool 52 and seal 30. Mask 50 may be positioned between tool 52 and seal 30 in any location and/or orientation with respect to tool 52 and seal 30 that enables mask 50 to function as described herein. For example, in the exemplary embodiment mask body 54 is positioned such that a portion of each seal tooth 36 is received within a corresponding opening 56 and such that mask body portions 70 each extend through a corresponding channel 40 between adjacent seal teeth 36. Moreover, in the exemplary embodiment, and for example, mask 50 is positioned such that flanges 72 extend radially outward relative to seal rotor axis of rotation 34. Once mask 50 is positioned with respect to tool 52 and seal 30, the coating is applied to seal teeth 36 and/or other portions of seal 30 using any suitable method, process, structure, and/or means, such as, but not limited to, spraying the coating on seal 30 using a plasma torch. During application of the coating, seal 30 is rotated relative to mask 50 and tool 52. For example, in some embodiments the relative rotation is provided by rotating seal 30 about axis 34 when mask 50 and tool 52 are generally stationary. However, and for example, in some embodiments the relative rotation is provided by rotating mask 50 and tool 32 about an axis (e.g. axis 34) when seal 30 is generally stationary. As seal 30 rotates relative to mask 50 and tool 52, each of seal teeth 36 rotates within and relative to a corresponding mask body opening 56. As the coating is applied to seal 30, and for example seal teeth 36, mask body portions 70 facilitate reducing or eliminating contact between channel radially inner surfaces 44 and the coating, and thus may facilitate preventing the coating from being undesirably deposited on channel surfaces 44. In some embodiments, mask body portions 70 may also facilitate reducing or eliminating contact between the coating and at least a portion of seal teeth sidewalls 42 and/or other portions of seal 30, and may thus also facilitate preventing the coating from being undesirably deposited on at least a portion of sidewalls 42 and/or other portions of seal 30. As described above, flanges 72 may further facilitate reducing or eliminating contact between the coating and surfaces 44, at least a portion of sidewalls 42, and/or other portions of seal 30. In some embodiments, mask 50 is positioned with respect to seal 30 before grit-blasting seal 30 to facilitate shielding channel surfaces 44, at least a portion of seal teeth sidewalls 42, and/or other portions of seal 30 from the abrasive material sprayed during the grit blasting.

The above-described masks, assemblies, and/or methods may facilitate cost-effective and/or reliable fabrication of components. For example, the masks, assemblies, and/or methods described and/or illustrated herein may facilitate masking a plurality of seal sizes, shapes, types, configurations, and/or arrangements in an efficient and timely manner, which may result in reduced fabrication costs. Furthermore, and for example, the masks, assemblies, and/or methods described and/or illustrated herein may facilitate improving a quality and/or a repeatability of masking components in a cost-effective and reliable manner. For example, the masks, assemblies, and/or methods described and/or illustrated herein may facilitate reducing or eliminating chipping of the coating as compared to some known masks and/or methods thereof. Moreover, the masks described and/or illustrated herein may be reusable.

Although the masks, assemblies, and methods described and/or illustrated herein are described and/or illustrated with respect to turbine engine components, and more specifically to fabricating gas turbine engine components by masking all or a portion of a seal between adjacent seal teeth, practice of the masks, assemblies, and methods described and/or illustrated herein is not limited to masking a seal between adjacent seal teeth, masking gas turbine engine components, nor masking turbine engine components generally. Rather, the masks, assemblies, and methods described and/or illustrated herein are applicable to masking any portion of any object.

Exemplary embodiments of masks, assemblies, and methods are described and/or illustrated herein in detail. The masks, assemblies, and methods are not limited to the specific embodiments described herein, but rather, components of each mask and/or assembly, as well as steps of each method, may be utilized independently and separately from other components and steps described herein. Each component, and each method step, can also be used in combination with other components and/or method steps.

When introducing elements/components/etc. of the masks, assemblies, and methods described and/or illustrated herein, the articles "a", "an", "the" and "said" are intend portioned to mean that there are one or more of the element(s)/component(s)/etc. The terms "comprising", "including" and "having" are intend portioned to be inclusive and mean that there may be additional element(s)/component(s)/etc. other than the listed element(s)/component(s)/etc.

### PARTS LIST

| | |
|---|---|
| 10 | gas turbine engine |
| 12 | low pressure compressor |
| 14 | high pressure compressor |
| 16 | combustor |
| 18 | turbine |
| 18 | high pressure turbine |
| 20 | low pressure turbine |
| 24 | first shaft |
| 26 | second shaft |
| 30 | seal |
| 32 | rotor |
| 34 | axis of rotation |
| 36 | seal teeth |
| 38 | rows |
| 40 | channel |
| 42 | sidewalls |
| 44 | radially inner surface |
| 50 | mask |
| 51 | assembly |
| 52 | tool |
| 54 | mask body |
| 56 | openings |
| 58 | length |
| 60 | end portions |
| 62 | end portions |
| 64 | width |
| 66 | end portions |
| 68 | end portions |
| 70 | mask body portions |
| 72 | flanges |
| 74 | outer end portion |

## Claims

1. An assembly (51) comprising:
a mask (50) comprising a body (54) and an opening (56) within said body; and
a turbine engine component comprising a rotor (32) and at least one seal tooth extending radially outward from said rotor, said mask body positioned with respect to said component such that at least a portion of said seal tooth is received within said opening during rotation of said component relative to said mask, said mask body positioned with respect to said component such that said body is configured to facilitate reducing deposition of a coating to a portion of said component adjacent said seal tooth during application of the coating to at least a portion of said seal tooth.

2. An assembly (51) in accordance with Claim 1 wherein said component comprises a plurality of said seal teeth each extending radially outward along at least a portion of a circumference of said rotor (32), said plurality of seal teeth spaced apart along an axis of rotation (34) of said rotor.

3. An assembly (51) in accordance with Claim 1 or 2 wherein said mask body (54) comprises a plurality of said openings (56), said mask body positioned with respect to said component such that at least a portion of each of said plurality of seal teeth is received within an opening of said plurality of openings during rotation of said component relative to said mask (50) and such that said body is configured to facilitate reducing contact between the coating and at least a portion of a surface defined between adjacent seal teeth of said plurality of said seal teeth during application of the coating to said component.

4. An assembly (51) in accordance with any preceding Claim wherein said seal tooth extends substantially circumferentially around said rotor (32).

5. An assembly (51) in accordance with any preceding Claim further comprising a tool (52) configured to apply the coating to said seal tooth, wherein said mask body (54) is positioned at least partially between said tool and a portion of said component adjacent said seal tooth.

6. An assembly (51) in accordance with any Claim 5 wherein said tool (52) comprises a plasma torch.

7. An assembly (51) in accordance with any preceding Claim wherein said mask body (54) extends a length (58) between a pair of opposite end portions (go, 62), and said opening (56) comprises an elongate opening extending along a portion of said length between said pair of opposite body end portions (70).

8. An assembly (51) in accordance with Claim 7 wherein said opening (56) has a generally rectangular or a generally oval shape.

9. An assembly (51) in accordance with Claim 7 or Claim 8 wherein said opening (56) extends substantially parallel to said mask body length (58).

## Patentansprüche

1. Anordnung (51), aufweisend:
eine Maske (50) mit einem Körper (54) und einer Öffnung (56) in dem Körper; und
eine Turbinentriebwerkskomponente mit einem Rotor (32) und wenigstens einem sich von dem Rotor aus radial nach außen erstreckenden Dichtungszahn, wobei der Maskenkörper in Bezug auf die Komponenten dergestalt positioniert ist, dass wenigstens ein Abschnitt des Dichtungszahns in der Öffnung während der Drehung der Komponente in Bezug auf die Maske aufgenommen wird, wobei der Maskenkörper in Bezug auf die Komponente dergestalt positioniert ist, dass der Körper dafür eingerichtet ist, die Verringerung einer Abscheidung einer Beschichtung auf einem an den Dichtungszahn angrenzenden Abschnitt der Komponente während der Aufbringung der Beschichtung auf wenigstens einen Abschnitt des Dichtungszahns zu ermöglichen.

2. Anordnung (51) nach Anspruch 1, wobei die Komponente mehrere Dichtungszähne aufweist, die sich jeweils radial entlang wenigstens einem Abschnitt eines Umfangs des Rotors (32) nach außen erstrecken, wobei die mehreren Dichtungszähne entlang einer Rotationsachse (34) des Rotors in Abstand angeordnet sind.

3. Anordnung (51) nach Anspruch 1 oder 2, wobei der Maskenkörper (54) mehrere Öffnungen (56) aufweist, wobei der Maskenkörper in Bezug auf die Komponente dergestalt positioniert ist, dass wenigstens ein Abschnitt von jedem der mehreren Dichtungszähne in einer Öffnung von den mehreren Öffnungen während der Rotation der Komponente in Bezug auf die Maske (50) aufgenommen wird, und dergestalt, dass der Körper dafür eingerichtet ist, eine Verringerung des Kontaktes zwischen der Beschichtung und wenigstens einem Abschnitt einer Oberfläche zu ermöglichen, die zwischen benachbarten Dichtungszähnen von den mehreren Dichtungszähnen während der Aufbringung der Beschichtung auf der Komponente definiert ist.

4. Anordnung (51) nach einem der vorstehenden Ansprüche, wobei sich der Dichtungszahn im Wesentlichen in Umfangsrichtung um den Rotor (32) herum erstreckt.

5. Anordnung (51) nach einem der vorstehenden Ansprüche, welche ferner ein Werkzeug (52) aufweist, das dafür eingerichtet ist, die Beschichtung auf den Dichtungszahn aufzubringen, wobei der Maskenkörper (54) wenigstens teilweise zwischen dem Werkzeug und einem an den Zahn angrenzenden Abschnitt der Komponente positioniert ist.

6. Anordnung (51) nach Anspruch 5, wobei das Werkzeug (57) einen Plasmabrenner aufweist.

7. Anordnung (51) nach einem der vorstehenden Ansprüche, wobei sich der Maskenkörper (54) entlang einer Länge (58) zwischen einem Paar gegenüberliegender Endabschnitte (60, 62) erstreckt, und die Öffnung (56) eine längliche Öffnung aufweist, die sich entlang einem Abschnitt der Länge zwischen dem Paar gegenüberliegender Körperendabschnitte (70) erstreckt.

8. Anordnung (51) nach Anspruch 7, wobei die Öffnung (56) eine im Wesentlichen rechteckige oder im Wesentlichen ovale Form hat.

9. Anordnung (51) nach Anspruch 7 oder Anspruch 8, wobei sich die Öffnung (56) im Wesentlichen parallel zu der Maskenkörperlänge (58) erstreckt.

## Revendications

1. Ensemble (51) comportant :
un masque (50) comprenant un corps (54) et une ouverture (56) dans ledit corps ; et
une pièce de moteur de turbine comprenant un rotor (32) et au moins une dent d'étanchéité s'étendant radialement vers l'extérieur depuis ledit rotor, ledit corps de masque étant placé par rapport à ladite pièce de façon qu'au moins une partie de ladite dent d'étanchéité soit reçue dans ladite ouverture pendant la rotation de ladite pièce par rapport audit masque, ledit corps de masque étant placé par rapport à ladite pièce de façon que ledit corps soit agencé pour contribuer à réduire le dépôt d'un revêtement sur une partie de ladite pièce au voisinage immédiat de ladite dent d'étanchéité pendant l'application du revêtement sur au moins une partie de ladite dent d'étanchéité.

2. Ensemble (51) selon la revendication 1, dans lequel ladite pièce comprend une pluralité de dites dents d'étanchéité s'étendant chacune radialement vers l'extérieur sur au moins une partie d'une circonférence dudit rotor (32), ladite pluralité de dents d'étanchéité étant espacées les unes des autres sur un axe de rotation (34) dudit rotor.

3. Ensemble (51) selon la revendication 1 ou 2, dans lequel ledit corps (54) de masque comprend une pluralité de dites ouvertures (56), ledit corps de masque étant placé par rapport à ladite pièce de façon qu'au moins une partie de chaque dent de ladite pluralité de dents d'étanchéité soit reçue dans une ouverture de ladite pluralité d'ouvertures pendant la rotation de ladite pièce par rapport audit masque (50) et de façon que ledit corps soit agencé pour contribuer à réduire le contact entre le revêtement et au moins une partie d'une surface définie entre des dents d'étanchéité adjacentes parmi ladite pluralité de dites dents d'étanchéité pendant l'application du revêtement sur ladite pièce.

4. Ensemble (51) selon l'une quelconque des revendications précédentes, dans lequel ladite dent d'étanchéité s'étend sensiblement sur le pourtour dudit rotor (32).

5. Ensemble (51) selon l'une quelconque des revendications précédentes, comportant en outre un outil (52) conçu pour appliquer le revêtement sur ladite dent d'étanchéité, ledit corps (54) de masque étant placé au moins partiellement entre ledit outil et une partie de ladite pièce adjacente à ladite dent d'étanchéité.

6. Ensemble (51) selon la revendication 5, dans lequel ledit outil (52) consiste en une torche à plasma.

7. Ensemble (51) selon l'une quelconque des revendications précédentes, dans lequel ledit corps (54) de masque s'étend sur une longueur (58) entre une paire d'extrémité opposées (60, 62), et ladite ouverture (56) consiste en une ouverture allongée s'étendant sur une partie de ladite longueur, entre une paire d'extrémités opposées (70) du corps.

8. Ensemble (51) selon la revendication 7, dans lequel ladite ouverture (56) a une forme globalement rectangulaire ou globalement ovale.

9. Ensemble (51) selon la revendication 7 ou la revendication 8, dans lequel ladite ouverture (56) s'étend sensiblement parallèlement à ladite longueur (58) du corps de masque.
